# EUROPEAN PATENT APPLICATION

(11) **EP 4 645 036 A1**
(43) Date of publication of application: **05.11.2025**
(21) Application number: 24774533.4
(22) Date of filing: 16.02.2024
(51) Int. Cl.: G06F 3/01, A63F 13/285

(54) **OPERATION DEVICE**

(30) Priority: 17.03.2023 JP 2023043153
(71) Applicant: Murata Manufacturing Co., Ltd., Nagaokakyo-shi, Kyoto 617-8555 (JP)
(72) Inventor: OSAKI Koji, Nagaokakyo-shi, Kyoto 617-8555 (JP)
(74) Representative: Behr, Wolfgang
(86) International application number: PCT/JP2024/005587
(87) International publication number: WO 2024/195388

(57) **Abstract**

An operating device (10) includes an operating unit that receives an input from a user, a housing body (20) that supports the operating unit, one or more vibrating bodies capable of generating vibration, one or more grips that store the one or more vibrating bodies, and one or more coupling portions that couple the one or more grips to the housing body (20) in a relatively movable manner.

## Description

### Technical Field

The present disclosure relates to an operating device.

### Background Art

An operating device described in Patent Document 1 includes a housing body including a display panel and the like, an operating unit from which a user can input a signal, and a grip that covers a portion of the operating unit. The housing body and the operating unit are coupled to each other. In addition, the operating unit includes a vibrating body that vibrates the grip by generating vibration. When the vibrating body vibrates, the vibration is transmitted to a hand of the user that holds the grip.

### Citation List

### Patent Document

Patent Document 1: Japanese Unexamined Patent Application Publication No. 2017-037371

### Summary of Invention

### Technical Problem

In the operating device as described in Patent Document 1, the vibrating body vibrates the entire operating device including the operating unit and the grip. Accordingly, when an attempt is made to transmit vibration with the strength required for the hand of the user, a large vibrating body needs to be adopted.

### Solution to Problem

To solve the problem described above, an aspect of the present disclosure is an operating device including: an operating unit that receives an input from a user; a housing body that supports the operating unit; one or more vibrating bodies capable of generating vibration; one or more grips that store the one or more vibrating bodies; and one or more coupling portions that couple the one or more grips to the housing body in a relatively movable manner.

In the structure described above, since the individual grips are relatively movable with respect to the housing body, the vibration of the individual grips is less likely to escape to the housing body when the individual vibrating bodies vibrate. Accordingly, the individual grips can be vibrated with the necessary strength without using large vibrating bodies.

### Advantageous Effects of Invention

The vibrating bodies and the grips can be easily vibrated.

### Brief Description of Drawings

[Fig. 1] Fig. 1 is a front view of an operating device.
[Fig. 2] Fig. 2 is a back view of the operating device.
[Fig. 3] Fig. 3 is a bottom view of the operating device.
[Fig. 4] Fig. 4 is an enlarged cross-sectional view taken along line 4-4 in Fig. 2.
[Fig. 5] Fig. 5 is an enlarged cross-sectional view taken along line 5-5 in Fig. 2.
[Fig. 6] Fig. 6 is a back view of a modification of the operating device.
[Fig. 7] Fig. 7 is a bottom view of the modification of the operating device.

### Description of Embodiments

### <Operating device according to one embodiment>

An operating device according to one embodiment will be described with reference to the drawings. It should be noted that the drawings are illustrated as schematic views in which components are exaggerated to facilitate understanding. The dimensional ratios of components may differ from those of actual components or those in other drawings.

### (Overall structure)

An operating device 10 according to the present embodiment is an input device that transmits, to an external device, operating information corresponding to an input signal from a user.

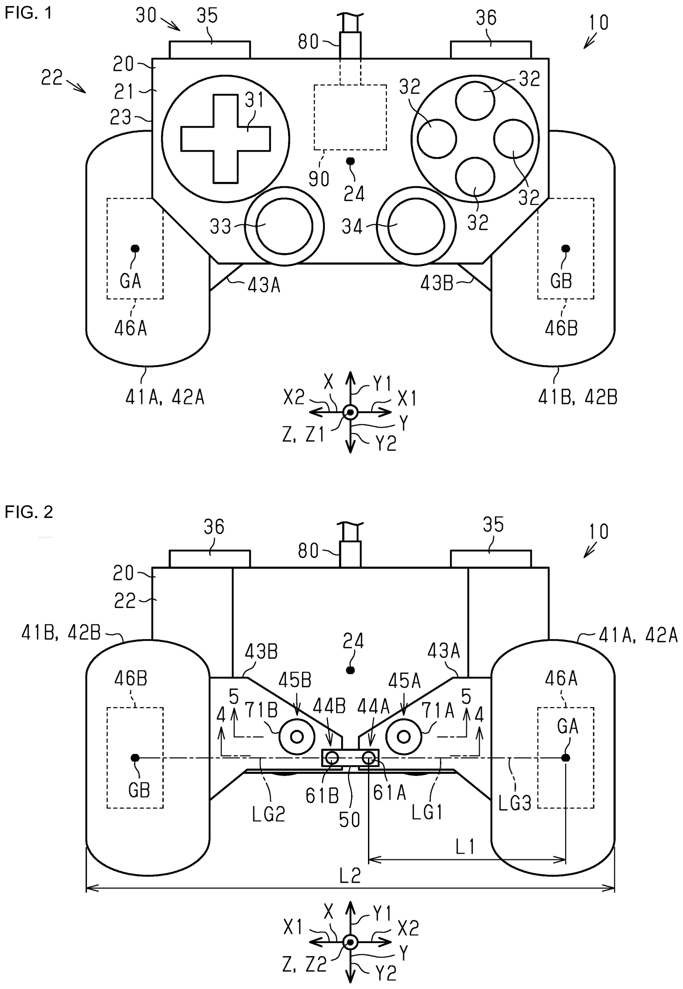

As illustrated in Fig. 1, the operating device 10 includes a housing body 20 and a plurality of operating units 30. The housing body 20 is a substantially rectangular parallelepiped box. That is, the housing body 20 has a cavity inside. In the following description, the axis parallel to the longitudinal direction of the housing body 20 is defined as a first axis X. In addition, one of axes orthogonal to the first axis X is defined as a second axis Y. The axis orthogonal to the first axis X and the second axis Y is defined as a third axis Z. In addition, one of directions along the first axis X is defined as a first positive direction X1, and the direction opposite to the first positive direction X1 of the directions along the first axis X is defined as a first negative direction X2. In addition, one of directions along the second axis Y is defined as a second positive direction Y1, and the direction opposite to the second positive direction Y1 of the directions along the second axis Y is defined as a second negative direction Y2. In addition, one of directions along the third axis Z is defined as a third positive direction Z1, and the direction opposite to the third positive direction Z1 of the directions along the third axis Z is defined as a third negative direction Z2.

The surface of the outer surfaces of the housing body 20 that faces the third positive direction Z1 is defined as a first surface 21. In other words, in plan view of the housing body 20 while facing the third negative direction Z2, the outer surface that can be seen is the first surface 21. In addition, as illustrated in Fig. 2, the surface of the outer surfaces of the housing body 20 that faces the third negative direction Z2 is defined as a second surface 22. In other words, in plan view of the housing body 20 while facing the third positive direction Z1, the outer surface that can be seen is defined as the second surface 22. In addition, the surface other than the first surface 21 and the second surface 22 of the outer surfaces of the housing body 20 is defined as a side surface 23. It should be noted that the boundary portion between the first surface 21 and the side surface 23 and the boundary portion between the second surface 22 and the side surface 23 may be unclear because the boundary portions are curved.

As illustrated in Fig. 1, the plurality of operating units 30 include a first operating unit 31, four second operating units 32, a third operating unit 33, a fourth operating unit 34, a fifth operating unit 35, and a sixth operating unit 36. The individual operating units 30 are attached to the housing body 20. That is, the housing body 20 supports the individual operating units 30. The individual operating units 30 are buttons, sticks, and the like that receive inputs from the user.

Specifically, the first operating unit 31 is a push button having a cross-shaped outline as viewed in the third positive direction Z1. The first operating unit 31 is exposed at the first surface 21 of the housing body 20. The first operating unit 31 is located in the first negative direction X2 and in the second positive direction Y1 on the first surface 21.

The four second operating units 32 are push buttons having a circular outline as viewed in the third positive direction Z1. The individual second operating units 32 are exposed at the first surface 21 of the housing body 20. The individual second operating units 32 are located in the first positive direction X1 and in the second positive direction Y1 on the first surface 21.

The third operating unit 33 is a so-called analog stick that has a substantially rod-like shape. The third operating unit 33 is exposed at the first surface 21 of the housing body 20. It should be noted that an input from the user is enabled by changing the inclination angle of the third operating unit 33 with respect to the housing body 20. The third operating unit 33 is located in the first negative direction X2 and in the second negative direction Y2 on the first surface 21. The fourth operating unit 34 is an analog stick similar to the third operating unit 33. The fourth operating unit 34 is exposed at the first surface 21 of the housing body 20. The fourth operating unit 34 is located in the first positive direction X1 and in the second negative direction Y2 on the first surface 21.

The fifth operating unit 35 is a substantially rectangular parallelepiped push button. The fifth operating unit 35 is exposed at the surface of the side surfaces 23 of the housing body 20 that faces the second positive direction Y1. The fifth operating unit 35 is located in the first negative direction X2. The sixth operating unit 36 is a substantially rectangular parallelepiped push button. The sixth operating unit 36 is exposed at the surface of the side surfaces 23 of the housing body 20 that faces the second positive direction Y1. The sixth operating unit 36 is located in the first positive direction X1 with respect to the fifth operating unit 35.

As illustrated in Fig. 2, the operating device 10 includes a first grip 41A, a first vibrating body 46A, a second grip 41B, and a second vibrating body 46B. Both the first grip 41A and the second grip 41B are coupled to the housing body 20. It should be noted that this coupling structure will be described later.

The first grip 41A includes a first grip housing 42A and a first overhanging portion 43A. The first grip housing 42A has a substantially cylindrical shape that extends in the secondary axis Y. Accordingly, the first grip housing 42A has a cavity inside. The first grip housing 42A is located in the third negative direction Z2, in the first negative direction X2, and in the second negative direction Y2 with respect to the gravity center 24 of the housing body 20. However, the term "gravity center" refers to the geometric gravity center with respect to the outer surface of the housing body 20 when no through-holes through which the operating units 30 and the like pass are assumed to be present in the outer surface of the housing body 20.

The first overhanging portion 43A has a substantially right-angled triangular plate shape. A one side portion of the triangular shape of the first overhanging portion 43A is connected to the surface of the first grip housing 42A located in the first positive direction X1. In addition, the first overhanging portion 43A overhangs in the first positive direction X1 from the surface. It should be noted that the first overhanging portion 43A is not in direct contact with the second surface 22 of the housing body 20. In addition, a gap is present between the first overhanging portion 43A and the second surface 22 of the housing body 20.

In addition, the first overhanging portion 43A has a first through-hole 44A and a screw hole 45A. The first through-hole 44A is a hole that passes through the first overhanging portion 43A. The first through-hole 44A is located near a vertex of the first overhanging portion 43A on the opposite side of the first grip housing 42A. The first overhanging portion 43A is coupled to the housing body 20 via the first through-hole 44A. It should be noted that this coupling structure will be described in detail later. The screw hole 45A passes through the first overhanging portion 43A. The screw hole 45A is located in the first negative direction X2 with respect to the first through-hole 44A.

The first grip housing 42A stores the first vibrating body 46A inside. Although not illustrated, the first vibrating body 46A includes voice coil motors, weights corresponding to the voice coil motors, and a cubic case that houses these components. The weights vibrate due to the force generated as current flows through the coils of the voice coil motors. When the weights vibrate, the case vibrates due to the vibration of the weights. Accordingly, the first vibrating body 46A vibrates in a direction along an axis orthogonal to the surface of the case by controlling the current flowing through the coils of the voice coil motors. Specifically, the first vibrating body 46A vibrates in a direction along the second axis Y. In addition, the vibration of the first vibrating body 46A is transmitted to the first grip 41A through the case of the first vibrating body 46A.

The second grip 41B includes a second grip housing 42B and a second overhanging portion 43B. The second grip housing 42B has a substantially cylindrical shape that extends in the secondary axis Y. The second grip housing 42B has a cavity inside. The second grip housing 42B is located in the third negative direction Z2, in the first positive direction X1, and in the second negative direction Y2 with respect to the gravity center 24 of the housing body 20.

The second overhanging portion 43B has a substantially right-angled triangular plate shape. One side portion of the triangular shape of the second overhanging portion 43B is connected to the surface of the second grip housing 42B located in the first negative direction X2. In addition, the second overhanging portion 43B overhangs in the first negative direction X2 from the surface. It should be noted that the second overhanging portion 43B is not in direct contact with the second surface 22 of the housing body 20. In addition, a gap is present between the second overhanging portion 43B and the second surface 22 of the housing body 20.

In addition, the second overhanging portion 43B has a second through-hole 44B and a screw hole 45B. The second through-hole 44B is a hole that passes through the second overhanging portion 43B. The second through-hole 44B is located near a vertex of the second overhanging portion 43B on the opposite side of the second grip housing 42B. The second overhanging portion 43B is coupled to the housing body 20 via the second through-hole 44B. It should be noted that this coupling structure will be described in detail later. The screw hole 45B passes through the second overhanging portion 43B. The screw hole 45B is located in the first positive direction X1 with respect to the second through-hole 44B.

The second grip housing 42B stores the second vibrating body 46B inside. Although not illustrated, the second vibrating body 46B has the same structure as the first vibrating body 46A. Accordingly, the second vibrating body 46B includes voice coil motors, weights corresponding to the voice coil motors, and a cubic case that houses these components. In addition, the vibration of the second vibrating body 46B is transmitted to the second grip 41B through the case of the second vibrating body 46B.

The second grip 41B includes the gravity center 24 of the housing body 20 and has a structure symmetrical to the first grip 41A with respect to a virtual plane orthogonal to the first axis X. In addition, the second vibrating body 46B includes the gravity center 24 of the housing body 20 and has a structure symmetrical to the first vibrating body 46A with respect to a virtual plane orthogonal to the first axis X. It should be noted that the term "symmetrical" allows for minor deviations due to manufacturing errors and the like.

### (Electrical structure of operating device)

As illustrated in Fig. 1, the operating device 10 includes a wiring line 80 and a control device 90. The wiring line 80 passes through the housing body 20. One end of the wiring line 80 is connected to the control device 90. The other end of the wiring line 80 is connected to an external device, which is not illustrated in the drawing. In addition, power can be supplied from the external device to the control device 90, the first vibrating body 46A, and the second vibrating body 46B through the wiring line 80.

The control device 90 is stored in the housing body 20. When the user operates the operating unit 30, the control device 90 inputs a signal corresponding to the operation to an external device through the wiring line 80.

In addition, the control device 90 controls the vibration of the first vibrating body 46A and the second vibrating body 46B. The control device 90 can generate senses of force in the individual vibrating bodies by controlling the vibration patterns of the individual vibrating bodies. In the present embodiment, the control device 90 generates a sense of force in the second positive direction Y1 or the second negative direction Y2 by controlling the vibration patterns in the direction along the second axis Y of the individual vibrating bodies. In addition, the control device 90 generates a sense of force in a clockwise or counterclockwise rotational direction by individually controlling the vibration patterns of the first vibrating body 46A and the second vibrating body 46B. It should be noted that a sense of force refers to a sense of drag received from an object. Accordingly, for example, when a sense of force in the second positive direction Y1 is generated in the first vibrating body 46A, the user feels as if the first vibrating body 46A is moving in the second positive direction Y1 even though the first vibrating body 46A is reciprocating at the same position.

It should be noted that the control device 90 may be configured as circuitry including one or more processors that execute various processes in accordance with a computer program (software). It should be noted that the control device 90 may also be configured as circuitry including one or more dedicated hardware circuits, such as an application-specific integrated circuit (ASIC) that executes at least some of various processes, or a combination thereof. Each of the processors includes a CPU and memories, such as a RAM and a ROM. The memories store program codes or instructions configured to cause the CPU to execute processes. The memories, that is, computer-readable media, include any available media that can be accessed by a general-purpose or dedicated computer.

### (Coupling structure between housing body and individual grips)

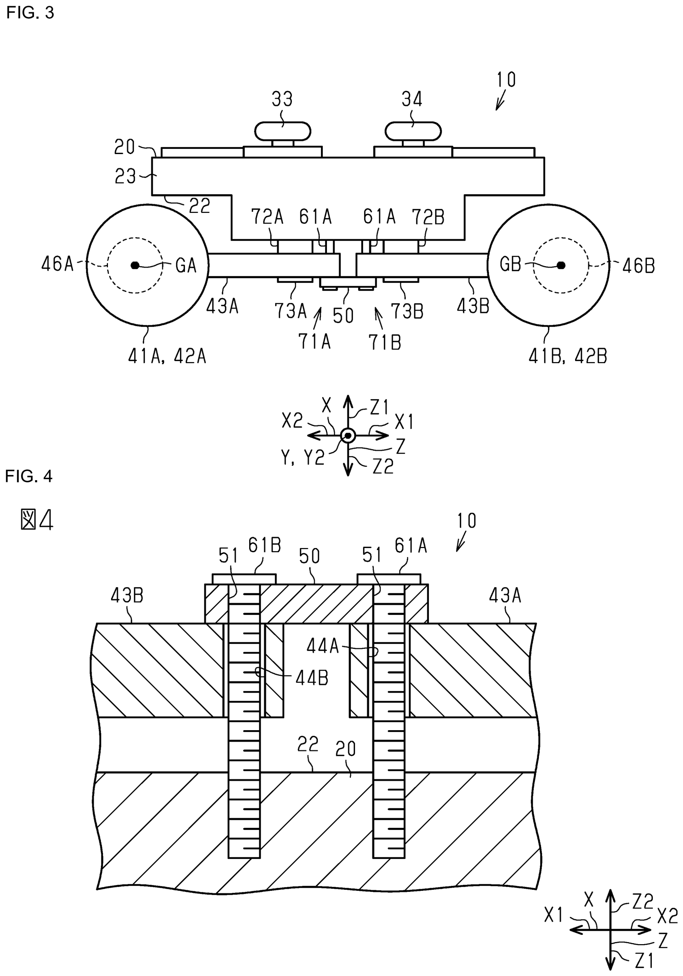

As illustrated in Fig. 2, the operating device 10 includes a connection member 50, a first coupling portion 61A, and a second coupling portion 61B. The connection member 50 has a rectangular plate shape elongated in the first axis X. As illustrated in Fig. 4, the connection member 50 has a total of two screw holes 51, one at each end portion of the connection member 50. The connection member 50 overlaps the first overhanging portion 43A of the first grip 41A and the second overhanging portion 43B of the second grip 41B as viewed in the third negative direction Z2. In addition, the connection member 50 spans both the first overhanging portion 43A and the second overhanging portion 43B.

The first coupling portion 61A is a screw. The first coupling portion 61A passes through one screw hole 51 of the connection member 50 and the first through-hole 44A of the first overhanging portion 43A. In addition, an end of the first coupling portion 61A extends to the housing body 20. As a result, as illustrated in Fig. 3, the first coupling portion 61A couples the connection member 50, the first overhanging portion 43A, and the housing body 20 to each other. In addition, as illustrated in Fig. 4, the outer diameter of the shaft portion of the first coupling portion 61A is smaller than the inner diameter of the first through-hole 44A. That is, a slight gap is present between the outer peripheral surface of the first coupling portion 61A and the inner peripheral surface of the first through-hole 44A.

The second coupling portion 61B is a screw. The second coupling portion 61B passes through one screw hole 51 of the connection member 50 and the second through-hole 44B of the second overhanging portion 43B. In addition, an end of the second coupling portion 61B extends to the housing body 20. As a result, as illustrated in Fig. 3, the second coupling portion 61B couples the connection member 50, the second overhanging portion 43B, and the housing body 20 to each other. In addition, as illustrated in Fig. 4, the outer diameter of the shaft portion of the second coupling portion 61B is smaller than the inner diameter of the second through-hole 44B. That is, a slight gap is present between the outer peripheral surface of the second coupling portion 61B and the inner peripheral surface of the second through-hole 44B.

As illustrated in Figs. 2 and 3, the operating device 10 includes a first damper 71A and a second damper 71B. As illustrated in Fig. 3, the first damper 71A is interposed between the housing body 20 and the first grip 41A. More specifically, the first damper 71A is fixed to the first overhanging portion 43A.

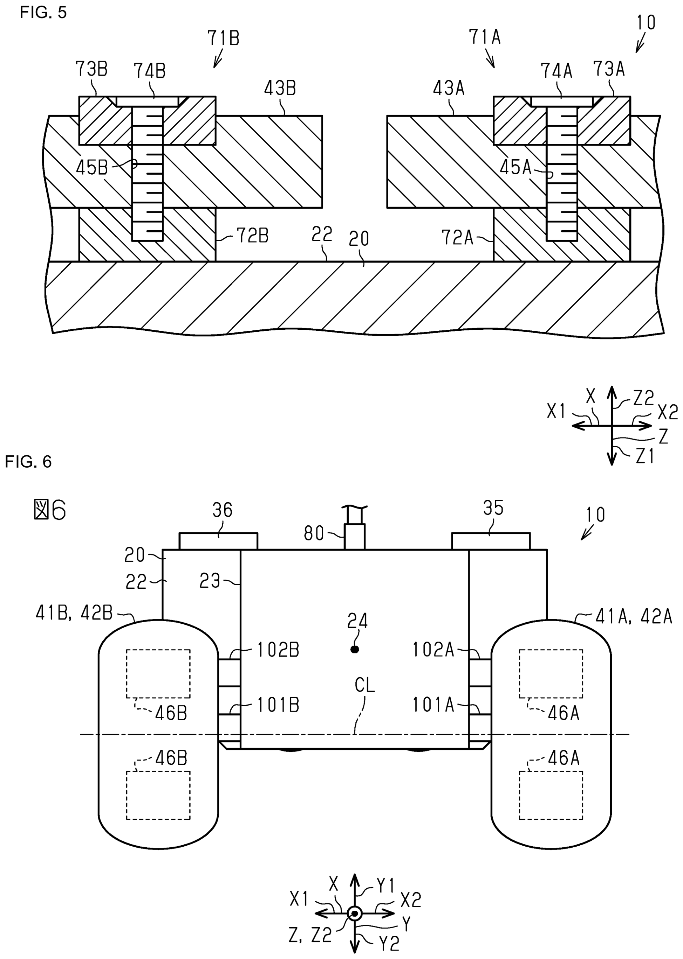

As illustrated in Fig. 5, the first damper 71A includes a first intermediate cushioning material 72A, a first back-side cushioning material 73A, and a first screw 74A. The first intermediate cushioning material 72A is located on the surface of the first overhanging portion 43A closer to the housing body 20 in the direction along the third axis Z. That is, the first intermediate cushioning material 72A is located between the first overhanging portion 43A and the housing body 20. In addition, the first intermediate cushioning material 72A blocks the screw hole 45A of the first overhanging portion 43A from the side in the third positive direction Z1. The first intermediate cushioning material 72A has a substantially circular shape in plan view. It should be noted that the thickness of the first intermediate cushioning material 72A is substantially the same as the distance between the first overhanging portion 43A and the housing body 20. The first intermediate cushioning material 72A is fixed to the housing body 20 with an adhesive or the like. The material of the first intermediate cushioning material 72A is a gel-like material, such as silicone.

The first back-side cushioning material 73A is located on a surface of the first overhanging portion 43A in the third negative direction Z2. In addition, the first back-side cushioning material 73A surrounds the opening of the screw hole 45A of the first overhanging portion 43A in the third negative direction Z2. The first screw 74A of the first damper 71A is inserted into the screw hole 45A while passing through the first back-side cushioning material 73A. In addition, the first screw 74A extends to the first intermediate cushioning material 72A. Accordingly, the first screw 74A fixes the first intermediate cushioning material 72A and the first back-side cushioning material 73A to the first overhanging portion 43A. The material of the first back-side cushioning material 73A is a gel-like material, such as silicone. Since the first damper 71A includes the first intermediate cushioning material 72A and the first back-side cushioning material 73A that are made of a gel-like material as described above, the elastic modulus of the first damper 71A is greater than the elastic modulus of the housing body 20 and the elastic modulus of the first grip 41A. In addition, more specifically, the elastic modulus of the first damper 71A is greater than the elastic modulus of a portion of the housing body 20 with which the first coupling portion 61A makes contact. In addition, the elastic modulus of the first damper 71A is greater than the elastic modulus of the inner peripheral surface of the first through-hole 44A of the first overhanging portion 43A. Accordingly, the first damper 71A is softer than the housing body 20 and the first grip 41A.

As illustrated in Fig. 3, the second damper 71B is interposed between the housing body 20 and the second grip 41B. More specifically, the second damper 71B is fixed to the second overhanging portion 43B.

As illustrated in Fig. 5, the second damper 71B includes a second intermediate cushioning material 72B, a second back-side cushioning material 73B, and a second screw 74B. The second intermediate cushioning material 72B is located on a surface of the second overhanging portion 43B closer to the housing body 20 in the direction along the third axis Z. That is, the second intermediate cushioning material 72B is located between the second overhanging portion 43B and the housing body 20. In addition, the second intermediate cushioning material 72B blocks the screw hole 45B of the second overhanging portion 43B from the side in the third positive direction Z1. The second intermediate cushioning material 72B has a substantially circular shape in plan view. It should be noted that the thickness of the second intermediate cushioning material 72B is substantially the same as the distance between the second overhanging portion 43B and the housing body 20. The second intermediate cushioning material 72B is fixed to the housing body 20 with an adhesive or the like. The material of the second intermediate cushioning material 72B is a gel-like material, such as silicone.

The second back-side cushioning material 73B is located on a surface of the second overhanging portion 43B in the third negative direction Z2. In addition, the second back-side cushioning material 73B surrounds the opening of the screw hole 45B of the second overhanging portion 43B in the third negative direction Z2. The second screw 74B of the second damper 71B passes through the screw hole 45B while passing through the second back-side cushioning material 73B. In addition, the second screw 74B extends to the second intermediate cushioning material 72B. Accordingly, the second screw 74B fixes the second intermediate cushioning material 72B and the second back-side cushioning material 73B to the second overhanging portion 43B. The material of the second back-side cushioning material 73B is a gel-like material, such as silicone. Since the second damper 71B includes the second intermediate cushioning material 72B and the second back-side cushioning material 73B that are made of a gel-like material as described above, the elastic modulus of the second damper 71B is greater than the elastic modulus of the housing body 20 and the elastic modulus of the second grip 41B. In addition, more specifically, the elastic modulus of the second damper 71B is greater than the elastic modulus of a portion of the housing body 20 with which the second coupling portion 61B makes contact. In addition, the elastic modulus of the second damper 71B is greater than the elastic modulus of the inner peripheral surface of the second through-hole 44B of the second overhanging portion 43B. Accordingly, the second damper 71B is softer than the housing body 20 and the second grip 41B.

### (Positional relationship between coupling portions and members)

As illustrated in Fig. 1, a first gravity center GA of the first vibrating body 46A is located in the first negative direction X2 and in the second negative direction Y2 with respect to the gravity center 24 of the housing body 20. In addition, a second gravity center GB of the second vibrating body 46B is located in the first positive direction X1 and in the second negative direction Y2 with respect to the operating unit 30. It should be noted that the gravity center of the vibrating body refers to the gravity center as the action point of gravity on the mass of the vibrating body when the vibrating body is located at the vibration center.

The direction in which the first grip 41A and the second grip 41B are arranged is defined as a first direction. As illustrated in Fig. 2, in the present embodiment, the first direction is the direction along the first axis X. A distance L1 from the first coupling portion 61A to the first gravity center GA of the first vibrating body 46A in the first direction is equal to or greater than one third of a maximum dimension L2 of the housing body 20 in the first direction. It should be noted that, although not illustrated, the distance from the second coupling portion 61B to the second gravity center GB of the second vibrating body 46B in the first direction is also equal to or greater than one third of the maximum dimension L2 of the housing body 20 in the first direction.

In addition, a line segment LG1 connecting the first coupling portion 61A and the first gravity center GA of the first vibrating body 46A is assumed. In the present embodiment, the line segment LG1 is substantially parallel to the first axis X. At this time, the first vibrating body 46A vibrates in a direction that intersects the line segment LG1. Specifically, as described above, the first vibrating body 46A vibrates in a direction along the second axis Y, which is substantially orthogonal to the line segment LG1.

Similarly, a line segment LG2 connecting the second coupling portion 61B and the second gravity center GB of the second vibrating body 46B is assumed. In the present embodiment, the line segment LG2 is substantially parallel to the first axis X. At this time, the second vibrating body 46B vibrates in a direction that intersects the line segment LG2. Specifically, as described above, the second vibrating body 46B vibrates in a direction along the second axis Y, which is substantially orthogonal to the line segment LG2.

In addition, a line segment LG3 connecting the first gravity center GA and the second gravity center GB is assumed. At this time, the first coupling portion 61A and the second coupling portion 61B present on the line segment LG3. In addition, both the first coupling portion 61A and the second coupling portion 61B are located near the midpoint of the line segment LG3.

### (Operation of the present embodiment)

In the operating device 10 according to the embodiment described above, the individual coupling portions and the individual grips have the following relationship. As illustrated in Fig. 4, a gap is present between the outer peripheral surface of the first coupling portion 61A and the inner peripheral surface of the first through-hole 44A of the first overhanging portion 43A. Accordingly, the first coupling portion 61A couples the first grip 41A to the housing body 20 in a relatively movable manner along any of the first axis X, the second axis Y, and the third axis Z. In addition, a gap is present between the outer peripheral surface of the second coupling portion 61B and the inner peripheral surface of the second through-hole 44B of the second overhanging portion 43B. Accordingly, the second coupling portion 61B couples the second grip 41B to the housing body 20 in a relatively movable manner along any of the first axis X, the second axis Y, and the third axis Z.

### (Effect of the present embodiment)

(1) In the embodiment described above, since the individual grips are relatively movable with respect to the housing body 20, the vibration of the individual grips is less likely to escape to the housing body 20 when the individual vibrating bodies vibrate. Accordingly, the individual grips can be vibrated with the necessary strength without using large vibrating bodies.
(2) According to the embodiment described above, the operating device 10 includes dampers between the housing body 20 and the individual grips. When the dampers elastically deformed, the vibration of the individual grips is attenuated. Accordingly, since the housing body 20 is less likely to vibrate even when the individual vibrating bodies vibrate, the vibration of the individual vibrating bodies is less likely to prevent the user from operating the input portion.
(3) In the embodiment described above, the individual vibrating bodies vibrate in a direction that intersects the line segment LG1 connecting the first coupling portion 61A and the first gravity center GA of the first vibrating body 46A to each other. In such a vibration direction, the vibration of the individual vibrating bodies is less likely to be transmitted to the individual coupling portions. Accordingly, the individual grips can be vibrated more efficiently. This also applies to the second vibrating body 46B and the line segment LG2 connecting the second coupling portion 61B and the second gravity center GB of the second vibrating body 46B to each other.
(4) In the embodiment described above, the second vibrating body 46B is located symmetrically to the first vibrating body 46A with respect to a virtual plane that includes the geometric gravity center 24 of the housing body 20. Since the operating device 10 is substantially bilaterally symmetrical, the vibration patterns of the individual vibrating bodies can be easily controlled.
(5) In the embodiment described above, the individual coupling portions are located closer to the second surface 22 of the housing body 20. Accordingly, the operation of the operating unit 30 by the user is less likely to be prevented. In addition, since the distance between the housing body 20 and the overhanging portions can be easily kept, the housing body 20 is less likely to make contact with the individual grips. Accordingly, the vibrating body can be easily vibrated.
(6) In the embodiment described above, when the first vibrating body 46A vibrates, the first grip 41A vibrates along an arc trajectory centered on the first coupling portion 61A. On the other hand, in the embodiment described above, the distance L1 from the first coupling portion 61A to the first gravity center GA of the first vibrating body 46A in the first axis X direction is equal to or greater than one third of the maximum dimension L2 of the housing body 20 in the first axis X direction. When the distance from the first coupling portion 61A to the first gravity center GA of the first vibrating body 46A is increased as described above, the vibration trajectory of the first grip 41A can be brought closer to a linear shape. Accordingly, the first grip 41A can be easily vibrated in a direction that intersects the first axis X. This also applies to the second coupling portion 61B, the second vibrating body 46B, and the second grip 41B.
(7) In the embodiment described above, the first coupling portion 61A and the second coupling portion 61B are located on a virtual line segment LG3 that connects the first gravity center GA and the second gravity center GB to each other. As a result, even when the individual vibrating bodies vibrate, the user can easily grip the operating device 10. In addition, the vibration patterns of the individual vibrating bodies can be easily designed and controlled.

### <Modifications>

The embodiment described above and the following modifications can be combined and practiced as long as the combination does not technically contradict.

### (Modification of overall structure)

- The operating device 10 is not limited to the example in the present embodiment. For example, the operating device 10 is applicable to general operating devices used by the user while holding the grip, such as the steering wheel of a car or the operating device of a medical equipment or the like.
- The shape of the housing body 20 is not limited to a substantially rectangular parallelepiped. The shape may be changed as appropriate according to the intended use.
- The structure of the operating unit 30 is not limited to the example in the embodiment described above. The operating unit 30 may be, for example, a touch panel or the like that receives an input from the user.
- The operating device 10 only needs to have at least one grip. In addition, the structure, such as the size and the shape of the grip, is not limited to the example in the embodiment described above.
- The shape of the overhanging portion is not limited to the example in the embodiment described above. For example, the first overhanging portion 43A may have an L-shape that extends in the third positive direction Z1 from the surface of the first grip 41A located in the third positive direction Z1 and bends in the first positive direction X1 halfway. In addition, the positions and sizes of the through-hole and the screw hole of the overhanging portion may be changed as appropriate. This also applies to the second grip 41B.
- The overhanging portions may be in direct contact with the housing body 20. When the individual grips are connected to the housing body 20 via the coupling portions in a relatively movable manner, the effect described in (1) can be obtained.
- The operating device 10 only needs to include at least one vibrating body. In addition, the operating device 10 may also include three or more vibrating bodies. For example, as illustrated in Fig. 6, the first grip 41A may store two first vibrating bodies 46A at both ends of the first grip housing 42A. In addition, the second grip 41B may store two second vibrating bodies 46B at both ends of the second grip housing 42B.
- The individual grips do not need to completely cover the vibrating bodies. That is, even when a portion of the case of the vibrating body is exposed, the portion only needs to be stored in the grip.
- The structure of the vibrating body is not limited to the example in the embodiment described above. The vibrating body only needs to vibrate without presenting sense of contact. In addition, the vibrating body may be able to vibrate not only in the second axis Y direction but also in the first axis X direction, the third axis Z direction, and the like.
- In the embodiment described above, the second vibrating body 46B does not need to be located symmetrically to the first vibrating body 46A with respect to a virtual plane that includes the geometric gravity center of the housing body 20. The positional relationship between the first vibrating body 46A and the second vibrating body 46B only needs to be set as appropriate in accordance with the overall shape of the operating device 10, the type of vibration to be presented to the user, and the like.
- One grip may store a plurality of vibrating bodies. For example, in the example illustrated in Fig. 6, the first grip housing 42A stores two first vibrating bodies 46A. The two first vibrating bodies 46A are separated from each other in a direction along the second axis Y. Similarly, the second grip housing 42B stores two second vibrating bodies 46B. The two second vibrating bodies 46B are separated from each other in a direction along the second axis Y.

### (Modification of electrical structure of operating device)

- The function, the structure, and the like of the wiring line 80 are not limited to the examples in the embodiment described above. For example, the housing body 20 may include a terminal to which a wiring line can be connected from the outside, and the operating device 10 may include a rechargeable battery in the housing body 20. In addition, the operating device 10 does not need to include the wiring line 80.
- The function, the structure, and the like of the control device 90 are not limited to the examples in the embodiment described above. The control device 90 does not need to input a signal through the wiring line 80. For example, the control device 90 may include a wireless communication module and may transmit, by wireless communication, a signal in accordance with an input from the operating unit 30 by the user. In addition, the operating device 10 does not need to include the control device 90.
- The vibration patterns of the vibrating body controlled by the control device 90 are not limited to the examples in the embodiment described above. The vibration patterns can be changed as appropriate in accordance with the number, the shape, the position, the size, the material, the function, and other elements of the vibrating body, the coupling portion, the grip, and other constituent members.
- When one grip stores the plurality of vibrating bodies as illustrated in the example in Fig. 6, the vibration directions of the individual vibrating bodies may be the same or different. It should be noted that, when the vibration directions of the individual vibrating bodies are different, senses of force in different directions can be presented to the user. In addition, a sense of force as if the grip is rotating can be presented to the user.

### (Modification of coupling structure between housing body and individual grips)

- The coupling portion does not need to be located on the surface of the outer surfaces of the housing body 20 that faces the third negative direction Z2. The number, the shape, the position, the size, the material, the function, and other elements of the coupling portions are not limited to the examples in the embodiment described above.
- In the embodiment described above, the outer diameter of the shaft portion of the first coupling portion 61A does not need to be smaller than the inner diameter of the first through-hole 44A. That is, a gap does not need to be present between the outer peripheral surface of the first coupling portion 61A and the inner peripheral surface of the first through-hole 44A. Even when the first coupling portion 61A is in contact with the first through-hole 44A, the first grip housing 42A is relatively movable with respect to the housing body 20 along the central axis of the first coupling portion 61A. Accordingly, the first grip 41A is more likely to vibrate than the first grip 41A in direct connect with the housing body 20. That is, the effect described in (1) can be obtained. This also applies to the second coupling portion 61B and the second through-hole 44B.
- When the first grip 41A and the second grip 41B are coupled to the housing body 20 in a relatively movable manner, the coupling structure can be changed as appropriate.

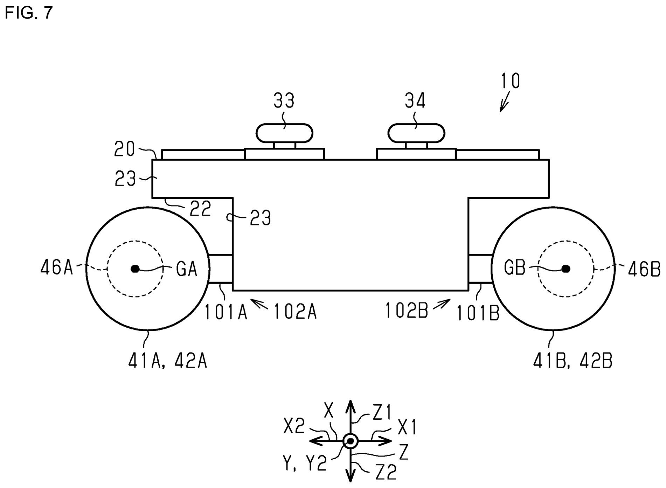

For example, in the example illustrated in Figs. 6 and 7, the operating device 10 includes a first rotation axis 101A and a second rotation axis 101B as the coupling portions. In addition, the operating device 10 includes a first cushioning material 102A and a second cushioning material 102B as the dampers. One end of the first rotation axis 101A is connected to the surface of the outer surfaces of the first grip housing 42A that faces the first positive direction X1. A portion including the other end of the first rotation axis 101A passes through the housing body 20. The first rotation axis 101A is rotatably supported by the housing body 20. Accordingly, the first grip 41A is relatively rotatable with respect to the housing body 20 about the central axial line of the first rotation axis 101A, together with the first rotation axis 101A. In addition, the first cushioning material 102A is interposed between the outer surface of the first grip housing 42A and the outer surface of the housing body 20. The material of the first cushioning material 102A is a gel-like material, such as silicone. One end of the second rotation axis 101B is connected to the surface of the outer surfaces of the first grip housing 42A that faces the first negative direction X2. A portion including the other end of the second rotation axis 101B passes through the housing body 20. The second rotation axis 101B is rotatably supported by the housing body 20. Accordingly, the second grip 41B is relatively rotatable with respect to the housing body 20 about the central axial line of the second rotation axis 101B, together with the second rotation axis 101B. In addition, the second cushioning material 102B is interposed between the outer surface of the second grip housing 42B and the outer surface of the housing body 20.

The material of the second cushioning material 102B is a gel-like material, such as silicone.

As in the modifications described above, the individual grips do not necessarily need to be relatively movable three-dimensionally with respect to the housing body 20 and may also be linearly movable two-dimensionally. In addition, the range in which the individual grips are relatively movable only needs to be a small range such as, for example, only a few millimeters.
- The operating device 10 does not need to include the dampers. Even when the dampers are not present, the effect described in (1) can be obtained.
- The structure of the dampers is not limited to the example in the embodiment described above. For example, the dampers may also include springs or the like that have an elastic modulus greater than the housing body 20 and the grips. In addition, the number, the positions, the size, and other elements of the dampers are not limited to the example in the embodiment described above. As long as the dampers are interposed between the grip housings and the housing body 20, the effect of attenuating the vibration transmitted to the housing body 20 can be obtained by the dampers.
- The materials of the first intermediate cushioning material 72A and the first back-side cushioning material 73A are not limited to the example in the embodiment described above. For example, the materials may be made of vibration-damping rubber or urethane.
- The dampers may also function as the coupling portions. In other words, in the embodiment described above, the connection member 50, the first coupling portion 61A, and the second coupling portion 61B may be omitted. In this case, the first damper 71A couples the first grip housing 42A and the housing body 20 to each other. In addition, the elastic deformation of the first damper 71A makes the first grip 41A relatively movable with respect to the housing body 20.

### (Modification of positional relationship between coupling portions and members)

- The distance L1 from the first coupling portion 61A to the first gravity center GA of the first vibrating body 46A in the first direction may be less than one third of the maximum dimension L2 of the operating device 10 in the first direction. Even when the distance L1 described above is small, the effect described in (1) can be obtained because the housing body 20 and the grips are connected to each other via the coupling portions. This also applies to the second coupling portion 61B, the second vibrating body 46B, and the second gravity center GB.
- The first coupling portion 61A and the second coupling portion 61B do not need to be present on the line segment LG3 connecting the first gravity center GA and the second gravity center GB to each other. In addition, none of the first coupling portion 61A and the second coupling portion 61B needs to be located near the midpoint of the line segment LG3 described above. Even when the positional relationship between the coupling portions and the gravity centers of the vibrating bodies varies, the effect described in (1) can be obtained.

It should be noted that, in the example illustrated in Fig. 6, the first rotation axis 101A and the second rotation axis 101B that serve as the coupling portions are located on a straight line CL that passes through the midpoint of the dimension of the first grip housing 42A in the second axis Y direction and the midpoint of the dimension of the second grip housing 42B in the direction along the second axis Y. Also in this case, the user can easily grasp the operating device 10 when the individual vibrating bodies vibrate.

### <Appendix>

The technical concept derived from the embodiments and the modifications described above will be described below.
[1] An operating device comprising:
   an operating unit that receives an input from a user;
   a housing body that supports the operating unit;
   one or more vibrating bodies capable of generating vibration;
   one or more grips that store the one or more vibrating bodies; and
   one or more coupling portions that couple the one or more grips to the housing body in a relatively movable manner.
[2] The operating device according to [1],
   wherein a damper is provided between the housing body and the one or more grips, and
   an elastic modulus of the damper is greater than an elastic modulus of the housing body and an elastic modulus of the one or more grips.
[3] The operating device according to [1] or [2],
   wherein, when a line segment connecting the one or more coupling portions and the one or more vibrating bodies is assumed, the vibrating body vibrates in a direction that intersects the line segment.
[4] The operating device according to any one of [1] to [3],
   wherein the one or more vibrating bodies include a first vibrating body and a second vibrating body,
   the one or more grips include a first grip that stores the first vibrating body and a second grip that stores the second vibrating body,
   the one or more coupling portions include a first coupling portion that couples the first grip and the housing body to each other and a second coupling portion that couples the second grip and the housing body to each other, and
   the second vibrating body is located symmetrically to the first vibrating body with respect to a virtual plane that includes a geometric gravity center of the housing body.
[5] The operating device according to [4],
   wherein, when one direction orthogonal to a direction in which the first grip and the second grip are arranged is defined as a positive direction, and a direction opposite to the positive direction is defined as a negative direction,
   the operating unit is exposed from the housing body on a surface of outer surfaces of the housing body that faces the positive direction, and
   the one or more coupling portions are located on a surface of the outer surfaces of the housing body that faces the negative direction.
[6] The operating device according to [4] or [5],
   wherein, when a direction in which the first grip and the second grip are arranged is defined as a first direction, and
   a distance from the first coupling portion to a gravity center of the first vibrating body in the first direction is equal to or greater than one third of a maximum dimension of the operating device in the first direction.
[7] The operating device according to any one of [4] to [6],
   wherein, when a line segment connecting a gravity center of the first vibrating body and a gravity center of the second vibrating body to each other is assumed, the first coupling portion and the second coupling portion are located on the line segment.

### Reference Signs List

- 10: operating device
- 20: housing body
- 30: operating unit
- 41A: first grip
- 41B: second grip
- 50: connection member
- 61A: first coupling portion
- 61B: second coupling portion
- 71A: first damper
- 71B: second damper
- 80: wiring line
- 90: control device

## Claims

1. An operating device comprising:
an operating unit that receives an input from a user;
a housing body that supports the operating unit;
one or more vibrating bodies capable of generating vibration;
one or more grips that store the one or more vibrating bodies; and
one or more coupling portions that couple the one or more grips to the housing body in a relatively movable manner.

2. The operating device according to Claim 1,
wherein a damper is provided between the housing body and the one or more grips, and
an elastic modulus of the damper is greater than an elastic modulus of the housing body and an elastic modulus of the one or more grips.

3. The operating device according to Claim 1 or 2,
wherein, when a line segment connecting the one or more coupling portions and the one or more vibrating bodies is assumed, the vibrating body vibrates in a direction that intersects the line segment.

4. The operating device according to any one of Claims 1 to 3,
wherein the one or more vibrating bodies include a first vibrating body and a second vibrating body,
the one or more grips include a first grip that stores the first vibrating body and a second grip that stores the second vibrating body,
the one or more coupling portions include a first coupling portion that couples the first grip and the housing body to each other and a second coupling portion that couples the second grip and the housing body to each other, and
the second vibrating body is located symmetrically to the first vibrating body with respect to a virtual plane that includes a geometric gravity center of the housing body.

5. The operating device according to Claim 4,
wherein, when one direction orthogonal to a direction in which the first grip and the second grip are arranged is defined as a positive direction, and a direction opposite to the positive direction is defined as a negative direction,
the operating unit is exposed from the housing body at a surface of outer surfaces of the housing body that faces the positive direction, and
the one or more coupling portions are located on a surface of the outer surfaces of the housing body that faces the negative direction.

6. The operating device according to Claim 4 or 5,
wherein, when a direction in which the first grip and the second grip are arranged is defined as a first direction, and
a distance from the first coupling portion to a gravity center of the first vibrating body in the first direction is equal to or greater than one third of a maximum dimension of the operating device in the first direction.

7. The operating device according to any one of Claims 4 to 6,
wherein, when a line segment connecting a gravity center of the first vibrating body and a gravity center of the second vibrating body to each other is assumed, the first coupling portion and the second coupling portion are located on the line segment.
